# EUROPEAN PATENT SPECIFICATION

(11) **EP 2 731 147 B1**
(45) Date of publication and mention of the grant of the patent: **24.03.2021**
(21) Application number: 12808154.4
(22) Date of filing: 11.05.2012
(51) Int. Cl.: H01L 31/02, H01L 31/048, H01L 31/05

(54) **SOLAR CELL MODULE**
SOLARZELLENMODUL
MODULE DE CELLULES SOLAIRES

(30) Priority: 04.07.2011 JP 2011148312
(43) Date of publication of application: 14.05.2014
(73) Proprietor: Panasonic Intellectual Property Management Co., Ltd., Osaka-shi, Osaka 540-6207 (JP)
(72) Inventor: ISHII, Yosuke, Moriguchi City Osaka 570-8677 (JP)
(74) Representative: Glawe, Delfs, Moll
(86) International application number: PCT/JP2012/062141
(87) International publication number: WO 2013/005475

(56) References cited:
- EP-A2- 2 081 237
- EP-A2- 2 112 696
- JP-A- 2007 281 044
- JP-A- 2011 009 460
- JP-A- 2011 054 721
- US-A1- 2011 073 165

## Description

### FIELD OF THE INVENTION

The present invention relates to a solar module and solar cell.

### BACKGROUND OF THE INVENTION

Interest in solar modules as an energy source with a low environmental impact has increased in recent years. Solar modules are equipped with a plurality of solar cells which are connected electrically by a wiring member as shown, for example, in Patent Document 1.

### Prior Art Documents

### Patent Documents

Patent Document 1: Laid-Open Patent Publication No. 2009-266848

Document EP 2 081 237 A2 relates to a solar cell module including first and second solar cell arranged in a first direction and electrically connected by a wiring member, wherein the first and second solar cells each include a light-receiving surface receiving light, a back surface provided on the opposite side of the light-receiving surface, and p-side and n-side electrodes formed on the back surface. The wiring member is connected to the n-side electrode of the first solar cell at a first connecting point and connected to the p-side electrode of the second solar cell at a second connecting point, wherein in a planar view the first and second connecting points are located on a line intersecting with the first direction.

JP 2011 054721 A discloses a solar module including a plurality of solar cells, each cell having first and second finger electrodes and first and second busbars. A wiring sheet connects adjacent cells by adhering to busbars and finger electrodes.

### SUMMARY OF THE INVENTION

### Problem Solved by the Invention

There is usually a difference in thermal expansion coefficient between the solar cells and the wiring member. As a result, when there is a change in temperature in the solar module, the solar cells and wiring member are subjected to thermal stress, and the wiring member may peel away from the solar cells.

It is an object of the present invention to provide a solar module in which peeling of the wiring member from the solar cells is suppressed.

### Means of Solving the Problem

The solar module of the present invention includes a plurality of solar cells, a wiring member, and an adhesive layer. Each solar cell has a photoelectric conversion unit, and first and second electrodes. The first and second electrodes are provided on the photoelectric conversion unit. Between adjacent solar cells, the wiring member electrically connects the first electrode of one solar cell to the second electrode of the other solar cell. The adhesive layer bonds the wiring member and the solar cells. The wiring member has an insulating substrate and wiring provided on the insulating substrate. The first and second electrodes each have a plurality of finger portions. The wiring has an adherend portion which is bonded to the solar cells by the adhesive layer. The adherend portion is provided over the finger portions and the section of the photoelectric conversion unit in which a finger portions are not provided.

The solar cell of the present invention includes a photoelectric conversion unit, and a first and a second electrode. The first and second electrodes are provided on the photoelectric conversion unit. The first and second electrodes are connected to the wiring member via the adhesive layer. Each of the first and second electrodes has a plurality of finger portions, a linear first busbar portion, and a second busbar portion. The first busbar portion is connected electrically to at least one of the plurality of finger portions. The second busbar portion is connected electrically to any of the plurality of finger portions not connected to the first busbar portion. The second busbar portion is arranged to the outside of the first busbar portion in the direction of extension of the first busbar portion. The electrical resistance of the first busbar portion is higher than the electrical resistance of the second busbar portion.

### Effect of the Invention

The present invention is able to provide a solar module in which peeling of the wiring member from the solar cells has been suppressed.

### BRIEF DESCRIPTION OF THE DRAWINGS

FIG. 1 is a simplified cross-sectional view of the solar module in an embodiment.
FIG. 2 is a simplified rear view of the solar module in the embodiment.
FIG. 3 is a simplified rear view of the solar cell string in the embodiment.
FIG. 4 is a simplified rear view of section IV in FIG. 3.
FIG. 5 is a simplified cross-sectional view from line V-V in FIG. 4.
FIG. 6 is a simplified enlarged view of area VI indicated by the dashed lines in FIG. 3.
FIG. 7 is a simplified rear view in which a portion of the solar cell string in a modified example has been enlarged.

### DETAILED DESCRIPTION OF THE INVENTION

The following is an explanation of examples of preferred embodiments of the present invention. The following embodiments are merely examples. The present invention is not limited by the following embodiments in any way.

Further, in each of the drawings referenced in the embodiments, members having substantially the same function are denoted by the same symbols. The drawings referenced in the embodiments are also depicted schematically. The dimensional ratios of the objects depicted in the drawings may differ from those of the actual objects. The dimensional ratios of objects may also vary between drawings. The specific dimensional ratios of the objects should be determined with reference to the following explanation.

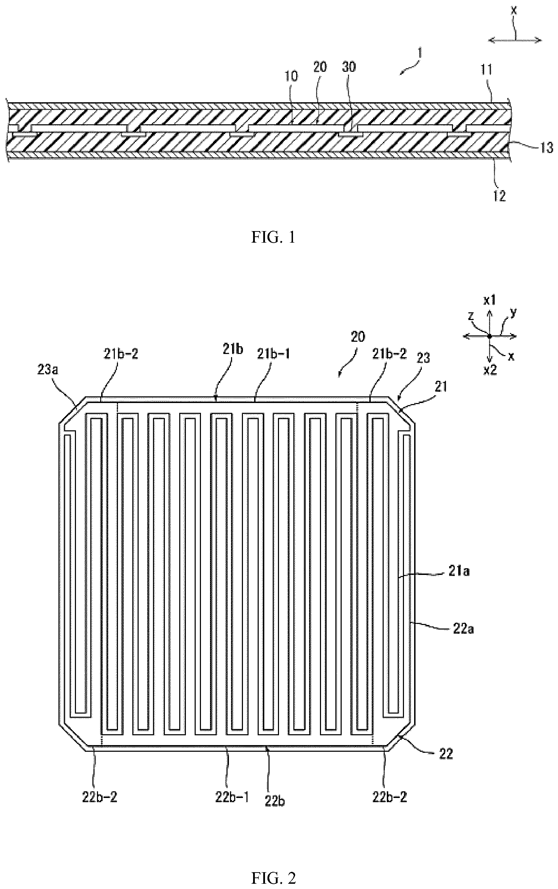

FIG. 1 is a simplified cross-sectional view of the solar module 1 in an embodiment. The solar module 1 includes a solar cell string 10. The solar cell string 10 is arranged between a first protecting member 11 positioned on the side of the light-receiving surface, and a second protecting member 12 positioned on the side of the back surface. A bonding layer 13 is provided between the first protecting member 11 and the second protecting member 12. The solar cell string 10 is sealed by the bonding layer 13.

The first protecting member 11 can be a glass substrate or a resin substrate. The second protecting member 12 can be a resin sheet, resin sheets with metal foil interposed therebetween, a glass substrate or a resin substrate. The bonding layer 13 can be a resin material such as an ethylene/vinyl acetate copolymer (EVA), polyvinylbutyral (PVB), polyethylene (PE) or polyurethane (PU).

The solar cell string 10 includes a plurality of solar cells 20 arranged in a first direction (the x-direction). Each of the solar cells 20 has a photoelectric conversion unit 23. The photoelectric conversion unit 23 generates carriers such as electrons or holes when light is received.

The photoelectric conversion unit 23 may include a semiconductor substrate having one type of conductivity, a first semiconductor layer having the other type of conductivity arranged on a portion of the surface of the semiconductor substrate, and a second semiconductor layer having the one type of conductivity arranged on at least a portion of the surface of the semiconductor substrate in which the first semiconductor layer has not been arranged. In this case, a substantially intrinsic i-type semiconductor layer may be arranged between each of the first and second semiconductor layers and the semiconductor substrate. The photoelectric conversion unit 23 may include a semiconductor substrate having the one type of conductivity and provided with a p-type dopant diffusion area and an n-type dopant diffusion area.

The first and second electrodes 21, 22 are arranged on the photoelectric conversion unit 23. More specifically, each of the first and second electrodes 21, 22 is arranged on the same main surface 23a of the photoelectric conversion unit 23. More specifically, the main surface 23a of the photoelectric conversion unit 23 includes a p-type surface and an n-type surface. The first electrode 21 is arranged on one of the p-type and n-type surfaces, and the second electrode 22 is arranged on the other surface.

Each of the first and second electrodes 21, 22 are comb-shaped. Each of the first and second electrodes 21, 22 have a plurality of finger portions 21a, 22a and busbar portions 21b, 22b. Each of the finger portions 21a, 22a extends in the first direction (the x-direction). The finger portions 21a, 22a are interdigitated at intervals in a second direction (the y-direction) perpendicular to the first direction (x-direction).

The finger portions 21a are connected electrically to the busbar portion 21b. The busbar portion 21b is arranged on one side of the finger portions 21a in the x-direction. The busbar portion 21b is arranged on one end of the solar cells 20 in the x-direction from one end in the y-direction to the other end in the y-direction. The busbar portion 21b has a first busbar portion 21b-1 and a second busbar portion 21b-2. The configuration will be explained in greater detail below.

The plurality of finger portions 22a is connected electrically to the busbar portion 22b. The busbar portion 22b is arranged on the other side of the finger portions 22a in the x-direction. The busbar portion 22b is arranged on one end of the solar cells 20 in the x-direction from one end in the y-direction to the other end in the y-direction. The busbar portion 22b has a third busbar portion 22b-1 and a fourth busbar portion 22b-2. The configuration thereof will be explained in greater detail below.

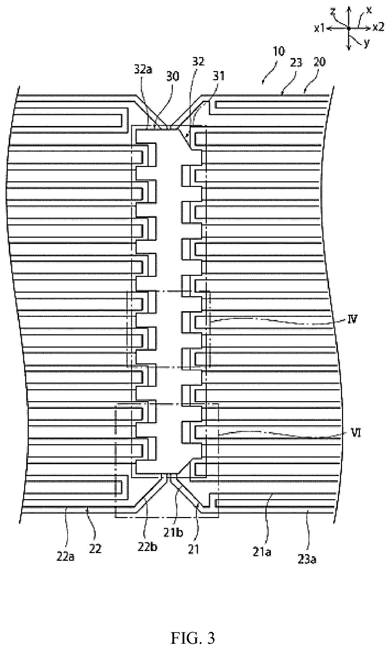

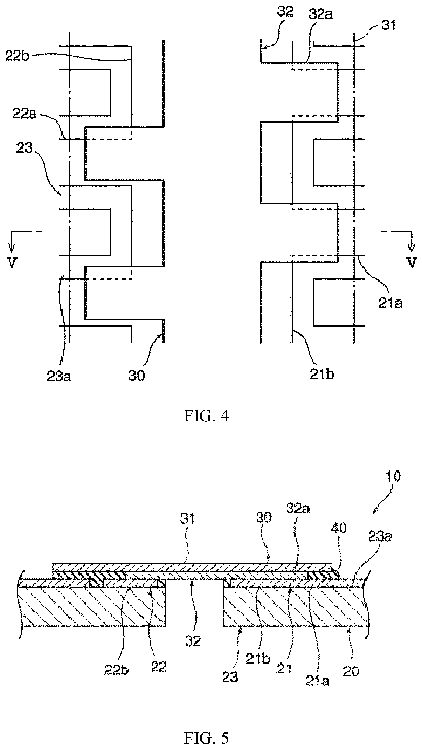

As shown in FIG. 3 and FIG. 4, the plurality of solar cells 20 is connected electrically by means of a wiring member 30. More specifically, between solar cells 20 adjacent to each other in the first direction (the x-direction), the first electrode 21 of one of the solar cells 20 is connected electrically to the second electrode 22 of the other solar cell by means of a wiring member 30.

The wiring member 30 and the solar cells 20 are bonded by means of the adhesive layer 40 shown in FIG. 5. The adhesive layer 40 may include a cured resin adhesive. The adhesive layer 40 may constitute a cured resin adhesive, or may include a cured resin adhesive throughout which conductive particles have been dispersed.

The wiring member 30 has an insulating substrate 31 and wiring 32 provided in the insulating substrate 31. Between solar cells 20 adjacent to each other in the first direction (the x-direction), the wiring 32 electrically connects the first electrode 21 of one of the solar cells 20 to the second electrode 22 of the other solar cell. In the example explained herein, the wiring 32 is provided on the main surface of the insulating substrate 31 on the side with the solar cells 20. However, some of the wiring 32 may be provided inside the insulating substrate 31.

The insulating substrate 31 may be flexible. The insulating substrate 31 can be made from an insulating material such as a resin or a ceramic.

The wiring 32 can be made of a metal such as Cu, Al or Ag, or an alloy including at least one of these metals.

The wiring 32 has an adherend portion 32a bonded to the solar cells 20 by the adhesive layer 40. The adherend portion 32a is provided over the finger portions 21a, 22a and over the photoelectric conversion unit 23 where the finger portions 21a, 22a are not provided. This increases the adhesive force of the adherend portion 32a to the solar cells 20 due to an anchoring effect. This makes the wiring 30 less likely to peel off the solar cells 20. As a result, greater reliability can be realized. It is not necessary for all of the adherend portions 32a to be provided over the finger portions 21a, 22a and over the photoelectric conversion unit 23 where the finger portions 21a, 22a are not provided.

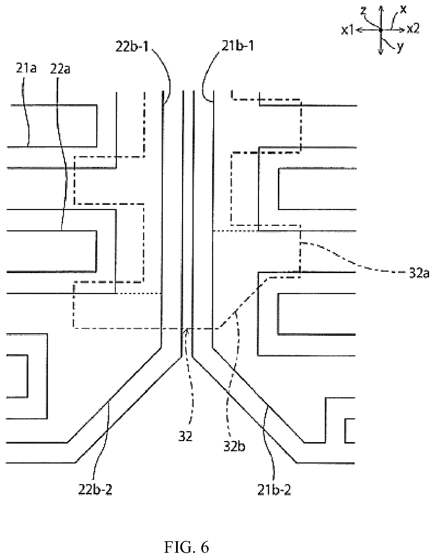

FIG. 6 is a simplified enlarged view of area VI indicated by the dashed lines in FIG. 3, which shows the configuration of the busbar portions 21b, 22b in greater detail. For convenience of explanation, the sections of the busbar portions 21b, 22b and the finger portions 21a, 22a covered by wiring 32 are denoted by the same solid lines as the sections not covered by wiring 32, and further description of the insulating substrate 31 has been omitted.

Busbar portion 21b has a first busbar portion 21b-1 and a second busbar portion 21b-2. In FIG. 6, the boundary between the first busbar portion 21b-1 and the second busbar portion 21b-2 is denoted by a broken line. However, in the electrode, the first busbar portion 21b-1 and the second busbar portion 21b-2 are formed continuously. The first busbar portion 21b-1 is arranged in the central portion in the y-direction, which is the direction of extension of the busbar portion 21b. Meanwhile, the second busbar portion 21b-2 is arranged on both ends in the y-direction. In other words, the second busbar portion 21b-2 is arranged to the outside of the first busbar portion 21b-1 in the y-direction, which is the direction of extension of the first busbar portion 21b-1.

The second busbar portion 21b-2 is connected electrically to at least one of the finger portions 21a among the finger portions 21a arranged on an end in the y-direction. The second busbar portion 21b-2 is connected electrically to the adherend portions 32a of the wiring 32 and to inclined portions 32b in the y-direction among the adherend portions 32a of the wiring 32. The second busbar portion 21b-2 collects current from at least one finger portion 21a among the finger portions 21a arranged on the end in the y-direction.

The first busbar portion 21b-1 is connected electrically to a finger portion 21a among the finger portions 21a positioned in the central portion in the y-direction not connected to the second busbar portion 21b-2. The electrical resistance of the first busbar portion 21b-1 is higher than the electrical resistance of the second busbar portion 21b-2. The thickness of the first busbar portion 21b-1 is equal to the thickness of the second busbar portion 21b-2, but the width of the first busbar portion 21b-1 is less than the width of the second busbar portion 21b-2.

More specifically, the width of the first busbar portion 21b-1 is nearly the same as the finger portions 21a. By narrowing the width of the first busbar portion 21b-1, loss due to recombination of carriers, especially loss due to recombination of minority carriers, can be suppressed. As a result, improved photoelectric conversion efficiency can be obtained.

The edge of an inclined portion 32b positioned on the edge of the adherend portions 32a in the y-direction is inclined in the x-direction. By providing the inclined portion 32b, the area of contact between the wiring 32 and the second busbar portion 21b-2 can be increased, and the electrical resistance can be reduced.

The third busbar portion 22b-1 and the fourth busbar portion 22b-2 have the same configuration as the first busbar portion 21b-1 and the second busbar portion 21b-2.

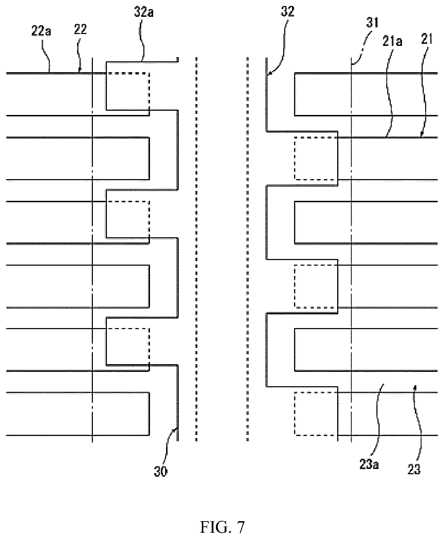

In the explanation of the example of an embodiment, each of the first and second electrodes 21, 22 include the busbar portions 21b, 22b. However, the first and second electrodes can achieve the same effect as long as they have a plurality of finger portions. In the modified example shown in FIG. 7, each of the first and second electrodes 21, 22 is a so-called busbarless electrode consisting of a plurality of finger portions 21a, 22a.

The modified example does not have the first busbar portion 21b-1 and third busbar portion 22b-1 shown in FIG. 6, but does have a second busbar portion 21b-2 and a fourth busbar portion 22b-2. In the case of a substantially octagonal semiconductor substrate with long sides and short sides, as in the modified example, busbar portions are not provided on the periphery of the long sides facing adjacent solar cells 20, but can be provided on the periphery of the short sides. When doing so, the finger portions 21a, 22a adjacent to the second busbar portion 21b-2 and the fourth busbar portion 22b-2 are connected to busbar portions 21b, 22b, but the other finger portions are not connected to busbar portions 21b, 22b. Even so, the effects are similar to those of the embodiment described above.

By making the first and second electrodes 21, 22 busbarless electrodes, as in the modified example, loss due to recombination of carriers, especially loss due to recombination of minority carriers, can be suppressed. As a result, improved photoelectric conversion efficiency can be obtained.

The present invention includes many other embodiments not described herein. Therefore, the technical scope of the present invention is defined solely by the items of the invention specified in the claims pertinent to the above explanation.

### Key to the Drawings

1: Solar module
20: Solar cell
21: 1st electrode
22: 2nd electrode
21a, 22a: Finger portion
21b, 22b: Busbar portion
23: Photoelectric conversion unit
23a: Main surface of photoelectric conversion unit
30: Wiring member
31: Insulating substrate
32: Wiring
32a: Adherend portion
40: Adhesive layer

## Claims

1. A solar module comprising:
a plurality of solar cells (20); and
a wiring (32) electrically connecting one of the solar cells (20) to another of the solar cells adjacent to the one solar cell, wherein
each of the solar cells (20) comprises:
a photoelectric conversion unit (23); and
a first electrode (21) and a second electrode (22) arranged on the photoelectric conversion unit (23) and connected to a wiring (32) via an adhesive layer (40);
the first electrode (21) having a plurality of finger portions (21a) and a busbar portion (21b) including a linear first busbar portion (21b-1) connected electrically to at least one of the plurality of finger portions (21a) of the first electrode (21) and a second busbar portion (21b-2) connected electrically to the finger portions, from among the plurality of finger portions (21a) of the first electrode (21), which are not connected to the first busbar portion (21b-1), the second busbar portion (21b-2) being arranged to the outside of the first busbar portion (21b-1) in a direction of extension of the first busbar portion (21b-1) ,
the second electrode (22) having a plurality of finger portions (22a) and a busbar portion (22b) including a linear third busbar portion (22b-1) connected electrically to at least one of the plurality of finger portions (22a) of the second electrode (22) and a fourth busbar portion (22b-2) connected electrically to the finger portions, from among the plurality of finger portions (22a) of the second electrode (22), which are not connected to the third busbar portion (22b-1), the fourth busbar portion (22b-2) being arranged to the outside of the third busbar portion (22b-1) in a direction of extension of the third busbar portion (22b-1), wherein
the electrical resistance of the first busbar portion (21b-1) is higher than the electrical resistance of the second busbar portion (21b-2), and
each of the busbar portion (21b) of the first electrode (21) of one solar cell and the busbar portion (22b) of the second electrode (22) of the other solar cell has an area covered by the wiring (32) and an area not covered by the wiring (32).

2. The solar module according to claim 1,
wherein the width of the first busbar portion (21b-1) in a longitudinal direction of the plurality of finger portions (21a) of the first electrode (21) is less than the width of the second busbar portion (21b-2) in the longitudinal direction of the plurality of finger portions (21a) of the first electrode (21), and
the width of the third busbar portion (22b-1) in a longitudinal direction of the plurality of finger portions (22a) of the second electrode (22) is less than the width of the fourth busbar portion (22b-2) in the longitudinal direction of the plurality of finger portions (22a) of the second electrode (22).

3. The solar module according to claim 1, wherein the adhesive layer (40) includes a cured resin adhesive throughout which conductive particles have been dispersed.

4. The solar module according to claim 3, wherein the wiring (32) has an adherend portion (32a) bonded to the solar cells (20) by the adhesive layer (40) such that the adherend portion (32a) is provided over the finger portions (21a, 22a) of the first and second electrodes (21, 22) and over the section of the photoelectric conversion unit (23) not provided with finger portions (21a, 22a) of the first and second electrodes (21, 22).

## Patentansprüche

1. Solarmodul mit:
einer Anzahl von Solarzellen (20) und
einer Verdrahtung (32), die eine der Solarzellen (20) mit einer anderen der Solarzellen neben der einen Solarzelle elektrisch verbindet, wobei
jede der Solarzellen (20) aufweist:
eine photoelektrische Wandlereinheit (23) und
eine erste Elektrode (21) und eine zweite Elektrode (22), die auf der photoelektrischen Wandlereinheit (23) angeordnet und über eine Klebeschicht (40) mit einer Verdrahtung (32) verbunden sind,
wobei die erste Elektrode (21) eine Anzahl von Fingerabschnitten (21a) und einen Sammelschienenabschnitt (21b) aufweist,
der einen linearen ersten Sammelschienenabschnitt (21b-1), der elektrisch mit mindestens einem der Anzahl von Fingerabschnitten (21a) der ersten Elektrode (21) verbunden ist, und einen zweiten Sammelschienenabschnitt (21b-2), der elektrisch mit den Fingerabschnitten verbunden ist, aufweist, aus der Anzahl der Fingerabschnitte (21a) der ersten Elektrode (21), die nicht mit dem ersten Sammelschienenabschnitt (21b-1) verbunden sind, wobei der zweite Sammelschienenabschnitt (21b-2) außerhalb des ersten Sammelschienenabschnitts (21b-1) in einer Erstreckungsrichtung des ersten Sammelschienenabschnitts (21b-1) angeordnet ist,
wobei die zweite Elektrode (22) eine Anzahl von Fingerabschnitten (22a) und einen Sammelschienenabschnitt (22b) aufweist, der einen linearen dritten Sammelschienenabschnitt (22b-1), der elektrisch mit mindestens einem der Anzahl von Fingerabschnitten (22a) der zweiten Elektrode (22) verbunden ist, und einen vierten Sammelschienenabschnitt (22b-2), der elektrisch mit den Fingerabschnitten verbunden ist, aufweist, aus der Anzahl von Fingerabschnitten (22a) der zweiten Elektrode (22), die nicht mit dem dritten Sammelschienenabschnitt (22b-1) verbunden sind, wobei der vierte Sammelschienenabschnitt (22b-2) außerhalb des dritten Sammelschienenabschnitts (22b-1) in einer Erstreckungsrichtung des dritten Sammelschienenabschnitts (22b-1) angeordnet ist, wobei
der elektrische Widerstand des ersten Sammelschienenabschnitts (21b-1) höher ist als der elektrische Widerstand des zweiten Sammelschienenabschnitts (21b-2) und
der Sammelschienenabschnitt (21b) der ersten Elektrode (21) der einen Solarzelle und der Sammelschienenabschnitt (22b) der zweiten Elektrode (22) der anderen Solarzelle jeweils einen von der Verdrahtung (32) bedeckten Bereich und einen nicht von der Verdrahtung (32) bedeckten Bereich aufweisen.

2. Solarmodul nach Anspruch 1,
wobei die Breite des ersten Sammelschienenabschnitts (21b-1) in einer Längsrichtung der Anzahl von Fingerabschnitten (21a) der ersten Elektrode (21) geringer ist als die Breite des zweiten Sammelschienenabschnitts (21b-2) in der Längsrichtung der Anzahl von Fingerabschnitten (21a) der ersten Elektrode ( 21) und
die Breite des dritten Sammelschienenabschnitts (22b-1) in einer Längsrichtung der Anzahl von Fingerabschnitten (22a) der zweiten Elektrode (22) kleiner ist als die Breite des vierten Sammelschienenabschnitts (22b-2) in der Längsrichtung der Anzahl von Fingerabschnitten (22a) der zweiten Elektrode (22).

3. Solarmodul nach Anspruch 1, wobei die Klebeschicht (40) einen ausgehärteten Harzklebstoff enthält, in dem leitfähige Partikel dispergiert sind.

4. Solarmodul nach Anspruch 3, wobei die Verdrahtung (32) einen Klebeabschnitt (32a) aufweist, der durch die Klebeschicht (40) so mit den Solarzellen (20) verbunden ist, dass der Klebeabschnitt (32a) über den Fingerabschnitten (21a, 22a) der ersten und zweiten Elektrode (21, 22) und über dem nicht mit Fingerabschnitten (21a, 22a) der ersten und zweiten Elektrode (21, 22) versehenen Abschnitt der photoelektrischen Wandlereinheit (23) vorhanden ist.

## Revendications

1. Module solaire comprenant :
une pluralité de piles solaires (20) ; et
un câblage (32) connectant électriquement l'une des piles solaires (20) à une autre des piles solaires adjacentes à la pile solaire, dans lequel
chacune des piles solaires (20) comprend :
une unité de conversion photoélectrique (23) ; et
une première électrode (21) et une deuxième électrode (22) agencées sur l'unité de conversion photoélectrique (23) et connectées à un câblage (32) via une couche adhésive (40) ;
la première électrode (21) ayant une pluralité de portions de doigt (21a) et une portion de barre omnibus (21b) comportant une première portion de barre omnibus (21b-1) linéaire connectée électriquement à au moins l'une de la pluralité de portions de doigt (21a) de la première électrode (21) et une deuxième portion de barre omnibus (21b-2) connectée électriquement aux portions de doigt, parmi la pluralité de portions de doigt (21a) de la première électrode (21), qui ne sont pas connectées à la première portion de barre omnibus (21b-1), la deuxième portion de barre omnibus (21b-2) étant agencée à l'extérieur de la première portion de barre omnibus (21b-1) dans une direction d'extension de la première portion de barre omnibus (21b-1),
la deuxième électrode (22) ayant une pluralité de portions de doigt (22a) et une portion de barre omnibus (22b) comportant une troisième portion de barre omnibus (22b-1) linéaire connectée électriquement à au moins l'une de la pluralité de portions de doigt (22a) de la deuxième électrode (22) et une quatrième portion de barre omnibus (22b-2) connectée électriquement aux portions de doigt, parmi la pluralité de portions de doigt (22a) de la deuxième électrode (22), qui ne sont pas connectées à la troisième portion de barre omnibus (22b-1), la quatrième portion de barre omnibus (22b-2) étant agencée à l'extérieur de la troisième portion de barre omnibus (22b-1) dans une direction d'extension de la troisième portion de barre omnibus (22b-1),
dans lequel
la résistance électrique de la première portion de barre omnibus (21b-1) est supérieure à la résistance électrique de la deuxième portion de barre omnibus (21b-2), et
chacune de la portion de barre omnibus (21b) de la première électrode (21) d'une pile solaire et de la portion de barre omnibus (22b) de la deuxième électrode (22) de l'autre pile solaire a une zone couverte par le câblage (32) et une zone non couverte par le câblage (32).

2. Module solaire selon la revendication 1,
dans lequel la largeur de la première portion de barre omnibus (21b-1) dans une direction longitudinale de la pluralité de portions de doigt (21a) de la première électrode (21) est inférieure à la largeur de la deuxième portion de barre omnibus (21b-2) dans la direction longitudinale de la pluralité de portions de doigt (21a) de la première électrode (21), et
la largeur de la troisième portion de barre omnibus (22b-1) dans une direction longitudinale de la pluralité de portions de doigt (22a) de la deuxième électrode (22) est inférieure à la largeur de la quatrième portion de barre omnibus (22b-2) dans la direction longitudinale de la pluralité de portions de doigt (22a) de la deuxième électrode (22).

3. Module solaire selon la revendication 1, dans lequel la couche adhésive (40) comporte un adhésif en résine durcie dans laquelle des particules conductrices ont été dispersées.

4. Module solaire selon la revendication 3, dans lequel le câblage (32) a une portion adhérente (32a) liée aux piles solaires (20) par la couche adhésive (40) de sorte que la portion adhérente (32a) soit prévue au-dessus des portions de doigt (21a, 22a) des première et deuxième électrodes (21, 22) et au-dessus de la section de l'unité de conversion photoélectrique (23) non pourvue de portions de doigt (21a, 22a) des première et deuxième électrodes (21, 22).
